# EUROPÄISCHE PATENTANMELDUNG

(11) **EP 1 001 668 A2**
(43) Veröffentlichungstag der Anmeldung: **17.05.2000**
(21) Anmeldenummer: 99118702.2
(22) Anmeldetag: 22.09.1999
(51) Int. Cl.: H05K 7/14, H05K 9/00

(54) **Baugruppenträger**

(30) Priorität: 09.11.1998 DE 19851586
(71) Anmelder: VERO Electronics GmbH, 28279 Bremen (DE)
(72) Erfinder: Borschewski, Dietmar, 28197 Bremen (DE); Schröder, Rainer, 27721 Ritterhude (DE)
(74) Vertreter: Bohnenberger, Johannes, Dr.

(57) **Zusammenfassung**

Die Erfindung betrifft einen Baugruppenträger (1), insbesondere ein 19"-Gehäuse, mit einer ersten Seitenwand (6), einer zweiten Seitenwand (7), einer Rückwand (11), einer oberen Abdeckung (8), einer unteren Abdeckung (9) und einer Frontabdeckung (3), wobei mindestens die Frontabdeckung (3) über ein HF-Dichtungselement (4a-h) mit dem übrigen Baugruppenträger in einem mechanischen Kontakt steht.

Um bei einem HF-dichten Baugruppenträger zu ermöglichen, daß die in ihm eingeschobenen Einzelbaugruppen, wie insbesondere Leiterplatten, schnell und einfach aus dem Baugruppenträger herausgezogen und ersetzt werden können, ist erfindungsgemäß vorgesehen, daß die Frontabdeckung eine am Baugruppenträger (1) angelenkte Tür (3) ist, die über im Öffnungsbereich (2) der Tür (3) am Baugruppenträger (1) angebrachte Kontaktzungenkörper (4a-h) mit dem Baugruppenträger im mechanischen Kontakt steht - oder umgekehrt - und eine HF-Abschirmung herbeiführt.

## Beschreibung

Die Erfindung betrifft einen Baugruppenträger, insbesondere ein 19"-Gehäuse, entsprechend dem Oberbegriff des Anspruchs 1.

Solche Baugruppenträger dienen typischerweise zur Aufnahme von Leiterplatten, wie insbesondere von sogenannten Europakarten mit Frontplatten, wobei auf den Leiterplatten elektronische Bauelemente angeordnet sind. Um die auf den Leiterplatten vorgesehenen elektronischen Bauelemente vor dem negativen Einfluß von äußerer HF-Strahlung zu schützen, werden die Leiterplatten üblicherweise bei einem entsprechenden Umfeld einzeln gegen negative HF-Einstrahlung abgeschirmt. Die Einzelabschirmung jeder einzelnen der in dem Baugruppenträger angeordneten Leiterplatten ist aufwendig und damit teuer.

Für den in der Praxis sehr häufigen Fall, daß in einem einzigen Baugruppenträger lediglich Leiterplatten vorgesehen sind, auf denen lediglich elektronische Bauelemente angeordnet sind, die selbst keine HF-Strahlung abgeben, ist es wünschenswert, alle in dem betreffenden Baugruppenträger vorhandenen Leiterplatten gemeinsam durch einen HF-dichten Baugruppenträger abzuschirmen. Dann kann auf die aufwendige Einzelabschirmung jeder der in dem betreffenden Baugruppenträger angeordneten Leiterplatten verzichtet werden.

In der DE-C1-42 05 893 ist ein Baugruppenträger beschrieben, bei dem Maßnahmen ergriffen worden sind, um zu verhindern, daß störende HF-Strahlung in den Baugruppenträger eindringt und in dem Baugruppenträger angeordnete elektronische Bauelemente stört. Bei dem bekannten Baugruppenträger ist eine Frontplatte unter Zwischenlage einer HF-Dichtung auf den übrigen Baugruppenträger aufgeschraubt.

Im Laborbetrieb oder bei der Entwicklung von elektronischen Schaltungen, die teilweise sehr komplizierter Natur sind, ist es wünschenswert, entsprechende elektronische Schaltungen zu realisieren, indem in einen Baugruppenträger Leiterplatten eingeschoben werden, so daß diese schnell und unkompliziert gegen andere Leiterplatten ausgetauscht werden können. Diese wünschenswerten Verhältnisse sind bei dem bekannten Baugruppenträger nicht gegeben.

Daher liegt der Erfindung die Aufgabe zugrunde, einen HF-dichten Baugruppenträger der eingangs genannten Art dahingehend weiterzubilden, daß die in dem Baugruppenträger angeordneten elektronischen Schaltungen schnell und unkompliziert gegen andere elektronische Schaltungen, insbesondere gegen solche, die auf Leiterplatten angeordnet sind, ausgetauscht werden können, ohne daß hierbei die HF-Dichtigkeit des Baugruppenträgers beeinträchtigt ist.

Diese Aufgabe wird bei einem gattungsgemäßen Baugruppenträger durch die im Kennzeichen des Patentanspruchs 1 angegebenen Merkmale gelöst.

Ein wesentlicher Aspekt der Erfindung besteht darin, als Frontabdeckung des Baugruppenträgers eine am Baugruppenträger angelenkte Tür vorzusehen und im Öffnungsbereich der Tür am Baugruppenträger Kontaktzungenkörper oder andere geeignete Kontaktkörper vorzusehen, die einen mechanischen Kontakt zwischen dem Baugruppenträger und der geschlossenen Tür herstellen, wodurch eine HF-Abschirmung des Baugruppenträgers im Öffnungsbereich der Tür herbeigeführt wird. Selbstverständlich kann auch ein geeigneter Kontaktzungenkörper derart unmittelbar an der Tür angebracht werden, daß der Kontaktkörper beim Schließen der Tür einen mechanischen Kontakt mit dem Baugruppenträger herbeiführt und hierdurch für eine HF-Abschirmung des Öffnungsbereichs der Tür des Baugruppenträgers sorgt.

Vorzugsweise ist eine Vielzahl von Kontaktzungenkörpern im Öffnungsbereich der Tür am Baugruppenträger vorgesehen, so daß ein "Rundum-Kontakt" zwischen dem Baugruppenträger und der Tür gegeben ist. Vorzugsweise sind mehrere Kontaktkörper mit zueinander weitgehend äquidistanten Abständen, soweit dies bei den am Baugruppenträger gegebenen Abmessungen möglich ist, vorgesehen. Vorzugsweise handelt es sich bei den Kontaktkörpern um Kontaktzungenkörper.

Bei einer vorteilhaften Ausgestaltung der Erfindung ist vorgesehen, daß der Kontaktzungenkörper eine Klemmplatte aufweist, an die elastische Zungen einstückig angeformt sind. Um den mechanischen und/oder HF-Kontakt zwischen dem Kontaktkörper bzw. Kontaktzungenkörper herbeizuführen, ist bei einer vorteilhaften Ausgestaltung der Erfindung vorgesehen, im Türöffnungsbereich des Baugruppenträgers eine oder mehrere Klemmleisten vorzusehen, die zusammen mit der Augenwand des Baugruppenträgers eine Klemmvorrichtung zur Aufnahme des oder der Kontaktzungenkörper bzw. Kontaktkörper bilden. Alternativ oder ergänzend zur Klemmleiste kann natürlich auch vorgesehen werden, die Kontaktzungenkörper oder dergleichen unmittelbar mit dem Baugruppenträger im Türöffnungsbereich zu verbinden, wie z.B. durch Schraubverbindungen oder selbstklebende Kontaktkörper.

Bei einer vorteilhaften Ausgestaltung der Erfindung ist ferner vorgesehen, daß die Befestigungsebene der Frontplatten von in dem Baugruppenträger angeordneten Leiterplatten, wie insbesondere Europakarten, in Richtung auf die Rückseite des Baugruppenträgers vertieft ist. In diesem Fall kann vorteilhafterweise weiterhin ein Baugruppenträger verwendet werden, der ein Normmaß, wie beispielsweise das 19"-Normmaß für entsprechende Baugruppenträger, aufweist und der dennoch mit einer erfindungsgemäßen HF-dichten Tür verschlossen werden kann.

Um ihre Funktion erfüllen zu können, bestehen die im Türöffnungsbereich des Baugruppenträgers oder an der Tür des Baugruppenträgers vorgesehenen Kontaktzungenkörper bzw. Kontaktkörper zumindest teilweise aus einem sogenannten EMV-Schirmmaterial, wie z. B. Kupfer oder Kupferberyllium, das die HF-Dichtigkeit des Baugruppenträgers im Türöffnungsbereich herstellt oder verbessert.

Indem bei einer vorteilhaften Ausgestaltung der Erfindung elastische (Metall-)Zungen an der Klemmplatte bzw. Kontaktplatte des Kontaktzungenkörpers einstückig angeformt oder in sonstiger Weise angebracht sind, kann eine Anordnung geschaffen werden, bei der die Zungen nach der Montage der Kontaktzungenkörper an den Baugruppenträger oder an der Tür in die Türöffnung hineinweisen. Hierdurch kann vorteilhafterweise eine Anordnung geschaffen werden, bei der die Tür des erfindungsgemäßen Baugruppenträgers leicht zu öffnen und zu verschließen ist und dennoch den Frontbereich des Baugruppenträgers zuverlässig gegen HF-Einstrahlung von außen abschirmt.

Weitere vorteilhafte Ausgestaltungen der Erfindung sind in den Unteransprüchen angegeben.

Die Erfindung wird nachfolgend anhand von nicht notwendigerweise maßstäblichen Zeichnungen näher beschrieben, wobei gleiche oder gleichwirkende Teile mit denselben Bezugszeichen versehen sind und darum nicht nochmals näher erläutert werden. Es zeigen:
- Fig. 1: einen erfindungsgemäßen Baugruppenträger in einer sogenannten Tower-Ausführung;
- Fig. 2: einen Längsschnitt durch den Türöffnungsbereich des in Fig. 1 dargestellten Baugruppenträgers;
- Fig. 3: den Türöffnungsbereich des erfindungsgemäßen Baugruppenträgers und die Anordnung von Kontaktzungenkörpern im Türöffnungsbereich des Baugruppenträgers; und
- Fig. 4: einen erfindungsgemäßen Kontaktzungenkörper aus EMV-Schirmmaterial.

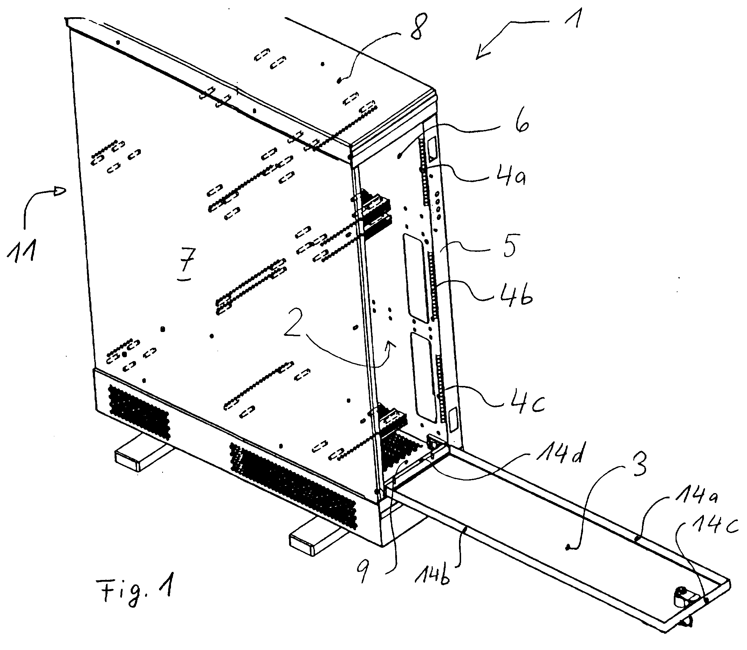

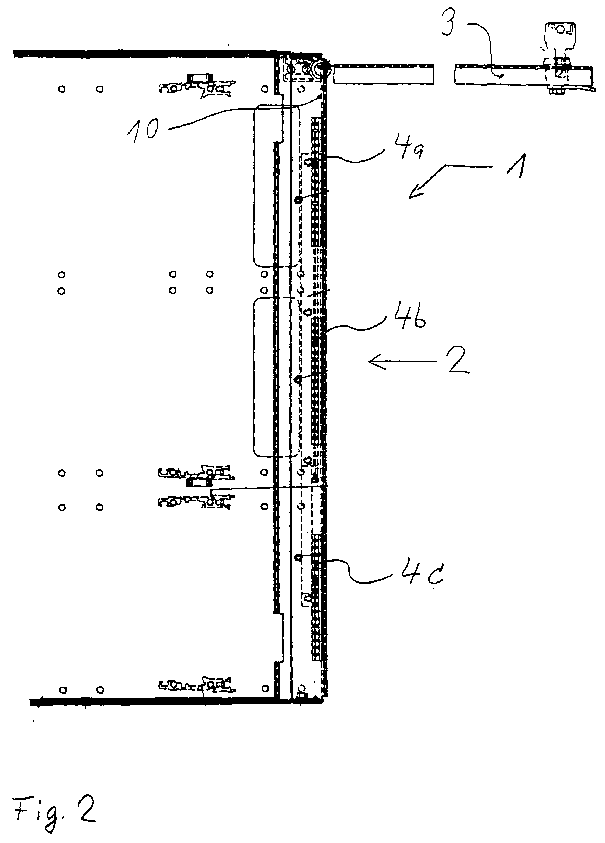

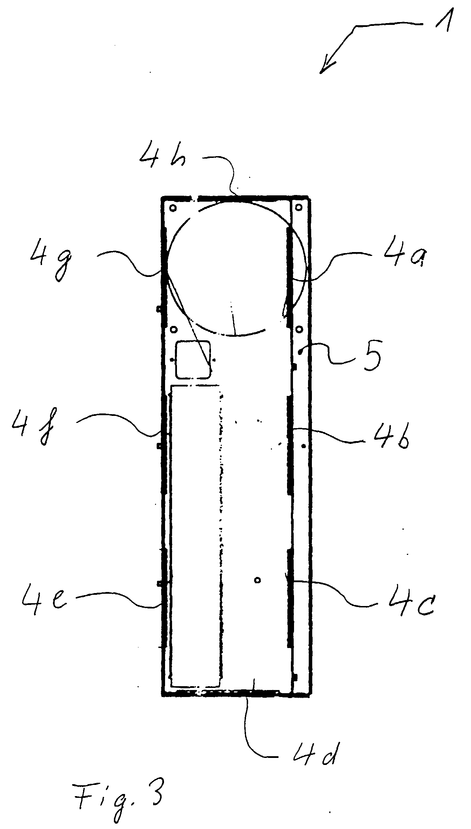

Fig. 1 zeigt einen Baugruppenträger 1, bei dem es sich bei dem nachfolgend beschriebenen Ausführungsbeispiel um ein aufgerichtetes und mit Fügen versehenes 19"-Gehäuse handelt, in einer sogenannten Tower-Anordnung. Der Baugruppenträger 1 weist eine erste Seitenwand 6, eine zweite Seitenwand 7, eine obere Abdeckung 8, eine untere Abdeckung 9 und eine Rückwand 11 auf. Am unteren Ende der ersten Seitenwand 6 und der zweiten Seitenwand 7 ist eine Tür 3 im Bereich der Türöffnung 2 derart angelenkt, daß die Tür die Frontseite des Baugruppenträgers 1 bündig mit den übrigen Frontteilen, wie einer Schalterleiste 5 des Baugruppenträgers 1, verschließen kann. Rund um den Türöffnungsbereich 2 des Baugruppenträgers 1 verläuft eine (metallische) Klemmleiste 10 innen im Baugruppenträger 1 und bildet zusammen mit dem "Türrahmen" des Baugruppenträgers 1 eine hinter dem Türrahmen liegende umlaufende Klemmvorrichtung, wie in Fig. 2 angedeutet. In die im Öffnungsbereich der Tür des Baugruppenträgers 1 in der beschriebenen Weise vorgesehene umlaufende Klemmvorrichtung sind Kontaktzungenkörper 4a-h mit zueinander weitgehend äquidistanten Abständen eingesteckt, wie in Fig. 3 dargestellt.

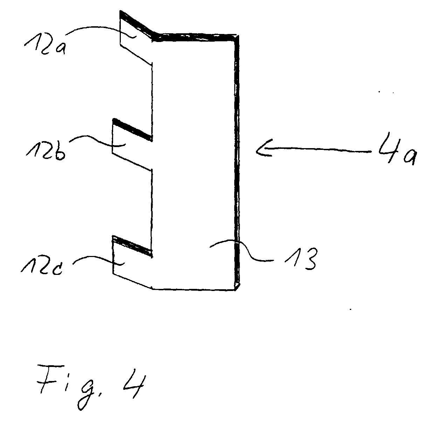

In Fig. 4 ist einer der Kontaktzungenkörper, beispielhaft der Kontaktzungenkörper 4a, schematisiert wiedergegeben. Die Kontaktzungenkörper 4a-h sind identisch. Der Kontaktzungenkörper 4a weist eine Klemmplatte 13 und eine Vielzahl eng benachbarter Kontaktzungen auf, von denen in der in Fig. 4 gezeigten schematischen Darstellung lediglich drei Kontaktzungen 12a-c gezeigt sind. Zur Herstellung des Kontaktzungenkörpers 4a werden an der linken Seite eines streifenförmigen EMV-Materials, wie Kupfer oder Kupferberyllium, Ausschnitte herausgestanzt, so daß das streifenförmige EMV-Material nach dem Ausstanzen eine kammartige Gestalt aufweist. Nach dem Ausstanzen werden die Zungen 12a-c durch einen Biegevorgang schräg nach hinten abgewinkelt. Der der Fig. 4 entsprechende Kontaktzungenkörper mit einer Vielzahl von Kontaktzungen, wird in äquidistanten Abständen (vergleiche Fig. 3) in die durch die umlaufende Klemmleiste 10 und den "Türrahmen" des Baugruppenträgers 1 gebildete Klemmvorrichtung eingeschoben und in ihrer Position gehalten. Im montierten Zustand weisen die Zungen 12a-c schräg von dem Türrahmen in das Innere des Baugruppenträgers 1 hinein. Wird die Tür 3 des Baugruppenträgers 1 geschlossen, drücken die Seitenwände 14a-d der Tür 3 die Kontaktzungen 12a-c gegen deren Federspannung beiseite, wodurch ein Kontakt zwischen der Tür 3 und dem Baugruppenträger 1 hergestellt und die EMV-Abschirmung im Bereich der Türöffnung 2 an der Frontseite des Baugruppenträgers 1 herbeigeführt wird. Vorzugsweise handelt es sich bei sämtlichen Abdeckungen des Baugruppenträgers 1 und bei der Tür 3 um Metallabdeckungen oder um Abdeckungen aus einem anderen EMV-Schirmmaterial bzw. einem Material, das für die Abschirmung von HF-Strahlung geeignet ist. Gegebenenfalls wird durch die Kontaktzungenkörper 4a-h neben einem mechanischen Kontakt auch ein elektrischer Kontakt zwischen der Tür 3 und dem Baugruppenträger 1 bzw. den Abdeckungen des Baugruppenträgers 1 hergestellt.

Es versteht sich, daß auch längere oder kürzere Kontaktzungenkörper 4a-h, ein umlaufender Kontaktzungenkörper oder auch ein anderer federnder Kontaktkörper im Bereich des Türrahmens des Baugruppenträgers 1 vorgesehen sein kann.

Um das Verschließen der Tür 3 des beispielhaft beschriebenen 19"-Baugruppenträgers zu ermöglichen, ist erfindungsgemäß vorgesehen, daß die Befestigungsebene der Frontplatten von in dem Baugruppenträger 1 untergebrachten Leiterplatten, wie insbesondere Europakarten, in das Innere des Baugruppenträgers 1 hinein vertieft ist. Ferner kann die Tür 3, wenn dies zweckmäßig ist, nicht an einer ihrer Schmalseiten, sondern an einer ihrer längeren Seiten an dem Baugruppenträger 1 angelenkt sein.

Eine solche Anordnung könnte z.B. dann zweckmäßig sein, wenn es sich nicht um eine Tower-Ausführung handelt, sondern um einen Baugruppenträger, der in einen Einbauschrank oder ein entsprechendes Gestell zusammen mit weiteren Baugruppenträgern montiert wird.

An dem erfindungsgemäßen HF-dichten Baugruppenträger ist insbesondere vorteilhaft, daß die Einzelbaugruppen keinen aufwendigen und damit teuren EMV-Schutz bzw. keine HF-Abschirmung zur Frontseite hin benötigen, da die erfindungsgemäße EMV-Tür für eine HF-Abschirmung sämtlicher Einzelbaugruppen bzw. der Leiterplatten etc. im Bereich der Türöffnung des Baugruppenträgers 1 sorgt. Die Tür 3 gibt nach dem Öffnen den Zugriff auf die in dem Baugruppenträger 1 angeordneten Einzelbaugruppen (nicht dargestellt) frei, so daß diese leicht entnommen und ersetzt werden können.

### Bezugszeichenliste

- 1: Baugruppenträger
- 2: Türöffnung
- 3: Tür
- 4a-h: Kontaktzungenkörper
- 5: Schalterleiste
- 6: erste Seitenwand
- 7: zweite Seitenwand
- 8: obere Abdeckung
- 9: untere Abdeckung
- 10: Klemmleiste
- 11: Rückwand
- 12a-c: Kontaktzungen
- 13: Klemmplatte
- 14a-d: Seitenwände der Tür

## Patentansprüche

1. Baugruppenträger (1), insbesondere ein 19"-Gehäuse, mit einer ersten Seitenwand (6), einer zweiten Seitenwand (7), einer Rückwand (11), einer oberen Abdeckung (8), einer unteren Abdeckung (9) und einer Frontabdeckung (3), wobei mindestens die Frontabdeckung (3) über ein HF-Dichtungselement (4a-h) mit dem übrigen Baugruppenträger in einem mechanischen Kontakt steht,
**dadurch gekennzeichnet,**
daß
- die Frontabdeckung eine am Baugruppenträger (1) angelenkte Tür (3) ist,
- die über mindestens einen im Öffnungsbereich (2) der Tür (3) am Baugruppenträger (1) angebrachten Kontaktkörper, wie einem Kontaktzungenkörper (4a-h), mit dem Baugruppenträger in mechanischem Kontakt steht - oder umgekehrt - und eine HF-Abschirmung herbeiführt.

2. Baugruppenträger nach Anspruch 1,
**dadurch gekennzeichnet,**
daß im Öffnungsbereich (2) der Tür (3) am Baugruppenträger (1) Klemmleisten (10) vorgesehen sind, die zusammen mit dem Baugruppenträger (1) eine Klemmvorrichtung zur Halterung der Kontaktzungenkörper (4a-h) bilden.

3. Baugruppenträger nach Anspruch 2,
**dadurch gekennzeichnet,**
daß rund um die Türöffnung (2) Klemmvorrichtungen in weitgehend äquidistanten Abständen vorgesehen sind.

4. Baugruppenträger nach einem der Ansprüche 1 bis 3,
**dadurch gekennzeichnet,**
daß der Kontaktzungenkörper (4a-h) eine Klemmplatte und an der Klemmplatte (13) einstückig angeformte elastische Zungen (12a-c) aufweist, die schräg nach oben von der Klemmplatte wegweisen.

5. Baugruppenträger nach Anspruch 4,
**dadurch gekennzeichnet,**
daß die Zungen (12a-c) des Kontaktzungenkörpers (4a-h) im montierten Zustand in die Türöffnung hineinweisen.

6. Baugruppenträger nach nach einem der Ansprüche 1 bis 5,
**dadurch gekennzeichnet,**
daß der Baugruppenträger (1) Leiterplatten, wie insbesondere sogenannte Europa-Karten, die mit Frontplatten versehen sind, aufnimmt und daß die Befestigungsebene für die Leiterplatten in Bezug auf die Türöffnung (2) in Richtung der Rückwand (11) des Baugruppenträgers (gegenüber einem herkömmlichen Baugruppenträger) zurückversetzt ist.
